Europäisches Patentamt

European Patent Office

Office européen des brevets

(11) Publication number: **0 240 921 B1**

# EUROPEAN PATENT SPECIFICATION

(45) Date of publication of patent specification: **27.07.94**  (51) Int. Cl.5: **H03M 13/00**, //G06F11/10

(21) Application number: **87104823.7**

(22) Date of filing: **01.04.87**

(54) **BCH code signal correcting system.**

(30) Priority: **03.04.86 JP 75549/86**

(43) Date of publication of application:
**14.10.87 Bulletin 87/42**

(45) Publication of the grant of the patent:
**27.07.94 Bulletin 94/30**

(84) Designated Contracting States:
**DE**

(56) References cited:
**US-A- 3 714 629**
**US-A- 4 107 652**

**G.C. Clark Jr., J. Bibb Cain: "Error-correction coding for digital communications", pages 181-225, Plenum Press, 1981, New York, London.**

(73) Proprietor: **KABUSHIKI KAISHA KENWOOD**
**2-5, Shibuya 1-chome,**
**Shibuya-ku**
**Tokyo 150(JP)**

(72) Inventor: **Shiraishi, Kenichi**
**Kabushiki Kaisha Kenwood**
**17-5, Shibuya 2-chome**
**Shibuya-ku Tokyo(JP)**
Inventor: **Kobayashi, Hirokazu**
**Kabushiki Kaisha Kenwood**
**17-5, Shibuya 2-chome**
**Shibuya-ku Tokyo(JP)**

(74) Representative: **Patentanwälte Leinweber & Zimmermann**
**Rosental 7/II Aufg.**
**D-80331 München (DE)**

# Description

The present invention relates to a BCH (Bose-Chaudhari-Hocquenghem) code signal correcting system, and more particularly to a BCH code signal correcting system for performing error correction using an index table.

## Related Background Art

A scheme using error correcting and error detecting codes has been widely used for information processing systems, particularly for a computer main storage which is necessary to have high reliability. Recently, use of codes having a higher capability of error correcting has been studied, and a BCH code is one of the leading codes. A decoder for BCH codes is described, for example, in "A Construction Method for Decoders of BCH Codes Using ROM's" by A. Yamagishi and H. Imai, Journal of Institute of Electronics, Information and Communication, December 1980, Vol. J63-D No. 12, pp. 103. According to this Article, error position data for all correctable errors are encoded and stored in a ROM in correspondence with syndromes. In this encoder, a syndrome is calculated from input data and supplied to the ROM as address data. The read-out error position data stored in the ROM is then decoded, parallel/serial converted, and is modulo-2 added to the original input data by an Exclusive-OR gate.

With a conventional construction as above, the capacity of the ROM is advantageously reduced since the error position data is stored in the ROM in the form of encoded data. However, the decoder and its associated circuits succeeding the ROM become complicated.

From prior art document US-A-4 107 652, a BCH code signal correcting system is known which includes means for generating error position data derived from a syndrome in an input BCH code signal, and correcting means for correcting the error in the input code signal. In this known system the error bit position information is completely stored in memory locations which have addresses corresponding to the syndromes, or only (t-1) error bit position information is stored in such a memory, the remaining error bit position information being determined by carrying out Exclusive-OR operations based on the syndromes and the error bit position information read from the memory.

From the document G.C. Clark Jr., J. Bibb Cain, Error-correction coding for digital communications, Pages 181-225, Plenum Press, 1981, New York, London is known a BCH code signal correcting system including means for generating error position data derived from a syndrome in an input BCH code signal, wherein the input code signal is delayed and a timing signal corresponding to the timing of the error position data is produced for correcting the error on the basis of this two signals.

It is the object of the present invention to provide a BCH code signal correcting system having a simplified arrangement.

## SUMMARY OF THE INVENTION

According to the present invention, there is provided a BCH code signal correcting system including means for generating error position data derived from a syndrome in an input BCH code signal, and correction means for correcting the error in the input code signal; wherein the input code signal data are further processed in a serial bit stream; the correcting system comprising means responsive to the error position data for producing a timing signal in dependence on a time interval between the error position and a reference position in the input BCH code signal; and means for delaying the input BCH code signal so that said timing signal timely corresponds to the error position in the delayed input BCH code signal; wherein said correction means is responsive to the timing signal and the delayed input code signal for correcting the error in the delayed input code signal; wherein said error position generating means includes memory means for storing error position binary code data addressed by the syndrome in the input BCH code signal, and said timing signal producing means includes a counter responsive to a load signal for being preset by the error position binary code data read out from said memory means and responsive to a clock signal for counting until a reference count to produce the timing signal; said timing signal being a carry signal.

According to another embodiment said correction means includes an Exclusive OR gate applied by said delayed input code signal and said carry signal.

According to another embodiment said memory means is an index table memory means for storing data corresponding to the difference between the error position data and a reference data in said preset counter, and wherein the syndrome is calculated from the input data, the calculated syndrome is applied as an address to said index table memory means to read out the data and the read-out data is applied as a preset value to said preset counter so that the error correction is conducted by an output which is issued when said preset counter counts to said reference data from the preset value.

According to one aspect of the present invention, a BCH code signal correcting system includes an index table ROM for storing error position data and a preset counter. A syndrome is calculated from the input BCH code signal, the calculated syndrome is applied as an address to the index table ROM to read out the error position data and the error position data is applied as a preset value to the preset counter. The error correction is conducted by an output which is issued when said preset counter counts to the reference data from the preset value.

The reference data of the preset counter herein referred to is a numeral data based on which the preset counter generates a carry or a borrow. For instance, in case of a base $2^n$ counter, the reference data becomes $(2^n-1)$ in decimal notation.

With the construction as above, a difference data between an error position data and a reference data is read from a ROM using a calculated syndrome, and loaded into a preset counter as its initial value. Succeedingly, when the count of clock pulses by the preset counter reaches the reference data, a carry or borrow is outputted therefrom.

The time when a carry or borrow is generated is so arranged to coincide with the error position of an input data, thus correcting the error in the input data.

Assume that the data stored in the ROM is a difference data between the error position data and the reference data. The number of clock pulses counted by the preset counter until it reaches the reference data, corresponds to the error bit position in an input data to accordingly correct an error bit.

BRIEF DESCRIPTION OF THE DRAWINGS

Fig. 1 is a block diagram of a BCH code signal correcting system according to the present invention; and
Figs. 2A to 2F are charts showing signal waveforms in the circuit of Fig. 1.

DESCRIPTION OF THE PREFERRED EMBODIMENT

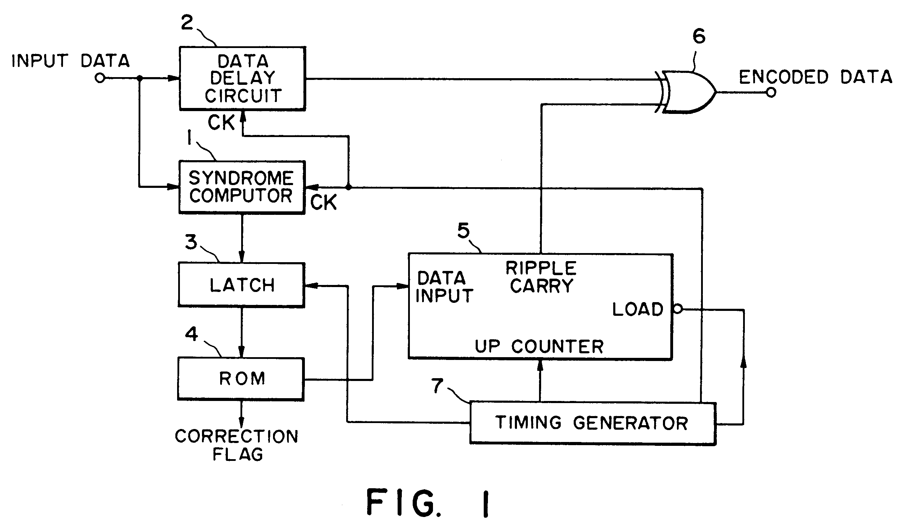

Fig. 1 is a block diagram showing the circuit configuration of an embodiment of the BCH code signal correcting system according to this invention.

An input data comprising a BCH code is supplied to a syndrome computer circuit 1 to calculate a syndrome. The input data is also supplied to a data delay circuit 2 constructed of a shift register, and delayed for matching the timings.

A syndrome calculated by the syndrome computer circuit 1 is supplied and latched by a latch 3 whose output is supplied as an address data to a ROM 4 storing error position data.

The error position data stored in the ROM 4 is a binary coded data of $[(2^n-1)-x]$, assuming that the block length of the input data is $\underline{y}$ ($2^n>y>2^{n-1}$) and that the error position is the "x"th bit from the start bit of the input data. If the block length of an input data is 63 bits, the error position data stored in the ROM 4 is only 6 bits.

The data addressed by the latch output and read from the ROM 4 is supplied as a preset data to a preset up-counter 5 to initiate up-count using the data as its initial value.

When the preset up-counter 5 reaches a full-count or a reference value, a ripple carry is outputted therefrom. This ripple carry is used as an error correcting signal, which together with an output from the data delay circuit 2 is supplied to an Exclusive-OR gate 6 to obtain therefrom an encoded data.

A timing generator 7 is used for matching timings of the circuit, and supplies a clock pulse signal to the syndrome computer 1, data delay circuit 2 and preset up-counter 5, a strobe pulse signal to the latch 3, and a load signal to the preset up-counter 5.

The data delay circuit 2 delays the input data for the period from when a syndrome calculation starts to when the data read from the ROM 4 is loaded in the preset up-counter 5.

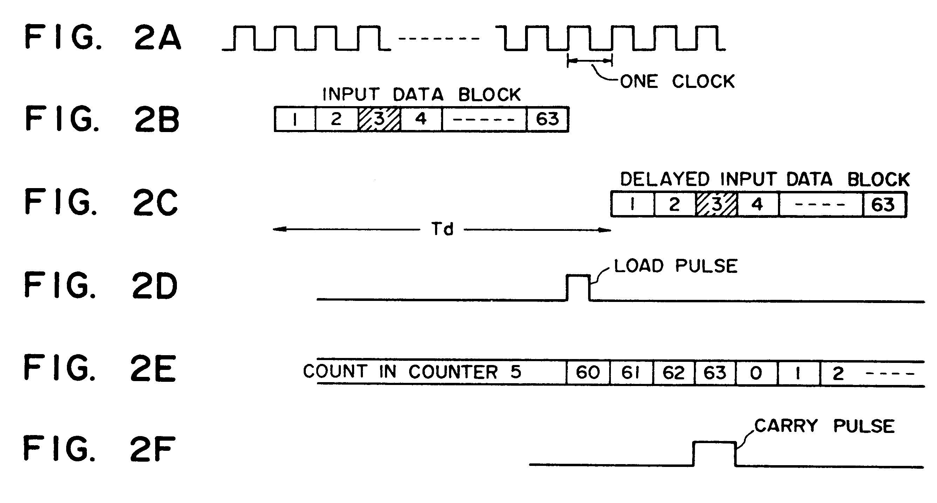

The operation will be described with reference to Figs. 2A to 2F, using the preset up-counter 5 constructed of a base 64 preset up-counter and having a reference value of $(2^6-1)$, and assuming that the block length of an input data is 63 bits.

Fig. 2A shows clocks outputted from the timing generator 7. If the 3rd bit from the start of the data block has an error when the BCH code input data block shown in Fig. 2B is input to the syndrome computer 1, then the ROM 4 outputs data [111100 = 60]. The input data block is delayed by the data delay circuit 2 by time Td (see Fig. 2C). In this embodiment, the time Td equals (input data block length time) + (1 clock time). A load pulse shown in Fig. 2D is issued when an input data block terminates, and the data of number 60 from the ROM 4 is preset at the counter 5 (see Fig. 2E). The counter 5 counts clock pulses starting from the preset value 60, and generates a carry pulse when the count reaches 63. As apparent from Figs. 2C and 2F, the timing of generating a carry pulse corresponds to the 3rd bit of the delayed input data block. The delayed input data block and the carry pulse are applied to the Exclusive-OR gate 6. Therefore, the 3rd bit of the input data block is inverted to be corrected at the output of the Exclusive-OR gate 6.

In the above embodiment, the block length of an input data is 63 bits. However, it is obvious that the block length is not limited thereto.

Further, as described previously, a counter, which starts counting from the clock pulse next to the preset value, is used as the preset up-counter 5. However, a counter, which starts counting from the clock pulse inputted during presetting, may be used instead. In this case, the error position data to be stored in the ROM 4 becomes $[(2^n-1) - x + 1]$, and the preset value is 61 in the similar case as above. A preset-down counter may be used.

As described so far, according to the present invention, a preset counter is used, and a difference data between the error position data and the preset counter reference value data is stored in the ROM. Thus, a decoder as well as its associated circuitries becomes unnecessary, so that the circuit arrangement of a BCH code encoder implemented in a medium scale integration circuit becomes simplified, thus remarkably reducing the number of integrated circuits.

Further, the timing circuit can be simplified and the circuit stability can be improved since the circuit uses only a single clock signal, as compared with a conventional, complicated timing circuit.

## Claims

1. A BCH code signal correcting system including means (1,3,4) for generating error position data derived from a syndrome in an input BCH code signal, and correction means (6) for correcting the error in the input code signal; wherein the input code signal data are further processed in a serial bit stream; the correcting system comprising

means (5,7) responsive to the error position data for producing a timing signal in dependence on a time interval between the error position and a reference position in the input BCH code signal; and

means (2) for delaying the input BCH code signal so that said timing signal timely corresponds to the error position in the delayed input BCH code signal;

wherein said correction means (6) is responsive to the timing signal and the delayed input code signal for correcting the error in the delayed input code signal;

**characterized in that**

said error position generating means (1,3,4) includes memory means (4) for storing error position binary code data addressed by the syndrome in the input BCH code signal, and

said timing signal producing means (5,7) includes a counter (5) responsive to a load signal for being preset by the error position binary code data read out from said memory means (4) and responsive to a clock signal for counting until a reference count to produce the timing signal; said timing signal being a carry signal.

2. The BCH code signal correcting system according to claim 1, **characterized in that** said correction means (6) includes an Exclusive OR gate applied by said delayed input code signal and said carry signal.

3. The BCH code signal correcting system of claim 2, **characterized in that** said memory means (4) is an index table memory means for storing data corresponding to the difference between the error position data and a reference data in said preset counter, and wherein the syndrome is calculated from the input data, the calculated syndrome is applied as an address to said index table memory means to read out the data and the read-out data is applied as a preset value to said preset counter so that the error correction is conducted by an output which is issued when said preset counter counts to said reference data from the preset value.

## Patentansprüche

1. BCH-Codesignal-Korrektursystem mit einer Einrichtung (1, 3, 4) zum Erzeugen von von einem Syndrom in einem Eingangs-BCH-Codesignal abgeleiteten Fehlerpositionsdaten und einer Korrektureinrichtung (6) zum Korrigieren des Fehlers in dem Eingangscodesignal; bei dem Eingangscodesignaldaten weiter in einem seriellen Bitstrom verarbeitet werden; wobei das Korrektursystem

eine auf die Fehlerpositionsdaten ansprechende Einrichtung (5, 7) zum Erzeugen eines Zeitgebersignals in Abhängigkeit von einem Zeitintervall zwischen der Fehlerposition und einer Referenzposition in dem Eingangs-BCH-Codesignal und

eine Einrichtung (2) zum derartigen Verzögern des Eingangs-BCH-Codesignals aufweist, daß das Zeitgebersignal zeitlich der Fehlerposition in dem verzögerten Eingangs-BCH-Codesignal entspricht;

wobei die Korrektureinrichtung (6) auf das Zeitgebersignal und das verzögerte Eingangscodesignal zum Korrigieren des Fehlers in dem verzögerten Eingangscodesignal anspricht;

dadurch gekennzeichnet,

daß die Fehlerpositions-Erzeugungseinrichtung (1, 3, 4) eine Speichereinrichtung (4) zum Speichern von mit dem Syndrom in dem Eingangs-BCH-Codesignal adressierten Fehlerpositions-Binärcode-Daten beinhaltet und

die Zeitgebersignalerzeugungseinrichtung (5, 7) einen Zähler (5) beinhaltet, der ansprechend auf ein Ladesignal durch die von der Speichereinrichtung (4) ausgelesenen Fehlerpositions-Binärcode-Daten voreingestellt wird und ansprechend auf ein Taktsignal bis zu einem Referenzzählwert zählt, um das Zeitgebersignal zu erzeugen; wobei das Zeitgebersignal ein Trägersignal ist.

2. BCH-Codesignal-Korrektursystem nach Anspruch 1, dadurch gekennzeichnet, daß die Korrektureinrichtung (6) ein Exklusiv-ODER-Gatter beinhaltet, an dem das verzögerte Eingangscodesignal und das Trägersignal anliegen.

3. BCH-Codesignal-Korrektursystem nach Anspruch 2, dadurch gekennzeichnet, daß die Speichereinrichtung (4) eine Indextabellen-Speichereinrichtung zum Speichern von Daten entsprechend der Differenz zwischen den Fehlerpositionsdaten und einem Referenzdatum in dem Voreinstellzähler ist und bei dem das Syndrom aus den Eingabedaten berechnet wird, wobei das berechnete Syndrom als eine Adresse an die Indextabellen-Speichereinrichtung gegeben wird, um die Daten auszulesen, und die ausgelesenen Daten als ein Voreinstellwert an den Voreinstellzähler gegeben werden, so daß die Fehlerkorrektur mit einem Ausgangssignal durchgeführt wird, das dann abgegeben wird, wenn der Voreinstellzähler von dem Voreinstellwert zu den Referenzdaten zählt.

**Revendications**

1. Système de correction du signal pour code BCH comprenant des moyens (1, 3, 4) pour produire des données de position d'erreur obtenues par un syndrome dans un signal d'entrée de code BCH, et un moyen de correction (6) pour corriger l'erreur dans le signal de code d'entrée ; dans lequel les données de signal de code d'entrée sont traitées en outre dans un flux de binaires en série ; le système de correction comprenant
un moyen (5, 7) répondant aux données de position d'erreur pour produire un signal de cadencement en fonction d'un intervalle de temps entre la position d'erreur et une position de référence dans le signal d'entrée de code BCH ; et
un moyen pour retarder le signal d'entrée de code BCH de façon que ledit signal de cadencement corresponde dans le temps à la position d'erreur dans le signal d'entrée retardé du code BCH ;
dans lequel ledit moyen de correction (6) répond au signal de cadencement et au signal d'entrée de code retardé pour corriger l'erreur dans le signal d'entrée de code retardé ;
caractérisé en ce que ledit moyen produisant la position d'erreur (1, 3, 4) comprend un moyen de mémoire (4) pour stocker des données de code binaire de position d'erreur adressées par le syndrome dans le signal d'entrée de code BCH, et
ledit moyen produisant le signal de cadencement (5, 7) comprend un compteur (5) répondant à un signal de charge pour être préréglé par les données de code binaire de position d'erreur lues dans ledit moyen de mémoire (4) et répondant à un signal d'horloge pour compter jusqu'à un compte de référence pour produire le signal de cadencement ; ledit signal de cadencement étant un signal de report.

2. Système de correction du signal pour code BCH selon la revendication 1, caractérisé en ce que ledit moyen de correction (6) comprend une porte OU exclusive appliquée par ledit signal de code d'entrée retardé et ledit signal de report.

3. Système de correction du signal pour code BCH selon la revendication 2, caractérisé en ce que ledit moyen de mémoire (4) est un moyen de mémoire de table d'index pour stocker des données correspondant à la différence entre la donnée de position d'erreur et une donnée de référence dans ledit compteur préréglé, et dans lequel le syndrome est calculé à partir des données d'entrée, le syndrome calculé est appliqué comme une adresse audit moyen de mémoire de table d'index pour lire la donnée, et la donnée lue est appliquée comme une valeur préréglée audit compteur préréglé de façon que la correction d'erreur soit effectuée par une sortie qui est émise lorsque ledit compteur préréglé compte jusqu'à ladite donnée de référence depuis ladite valeur préréglée.

FIG. I

EP 0 240 921 B1

FIG. 2A

INPUT DATA BLOCK

FIG. 2B

DELAYED INPUT DATA BLOCK

FIG. 2C

FIG. 2D

FIG. 2E

FIG. 2F

EP 0 240 921 B1